# EUROPEAN PATENT APPLICATION

(11) **EP 4 800 323 A2**
(43) Date of publication of application: **02.09.2026**
(21) Application number: 26156128.6
(22) Date of filing: 03.02.2026
(51) Int. Cl.: F25B 25/00

(54) **SYSTEMS AND METHODS FOR PUMPED REFRIGERANT SYSTEM CHARGE MANAGEMENT IN A DATA CENTER**

(30) Priority: 03.02.2025 US 202563753059 P; 20.11.2025 US 202519395035
(71) Applicant: Vertiv Corporation, Westerville, OH 43082 (US)
(72) Inventor: COLE, Andrew Nathan, Westerville, 43082 (US); KROUSE, Eric Matthew, Westerville, 43082 (US)
(74) Representative: Bryn-Jacobsen, Caelia

(57) **Abstract**

Systems and methods for providing consistent and reliable movement of refrigerant within a cooling system for a data center are disclosed. By implementing fluid transfer valves such that a thermosyphon heat exchanger fill loop allows refrigerant to circulate between an isolated refrigerant storage space and a heat exchanger, the data center is cooled more efficiently.

## Description

### CROSS-REFERENCE TO RELATED APPLICATIONS

This application claims the benefit of and priority to U.S. Provisional Patent Application No. 63/753,059, filed February 3, 2025, and U.S. Non-Provisional Patent Application No. 19/395,035, filed November 20, 2025.

### TECHNICAL FIELD

This disclosure relates to pumped refrigerant system charge management of heat rejecting plate heat exchanger (PHE) condensers.

### BACKGROUND

In a data center environment, refrigerant is circulated in order to maintain certain temperature ranges of computing devices and other Information Technology (IT) equipment within server racks. Previous implementations that attempt to protect a compressor included installing a liquid injection loop between an evaporator and the compressor on the compressed system. However, such implementations included a duplicate superheat-grade control setup, for example, thus requiring a complex and inefficient evaporator.

### SUMMARY

An example includes systems and methods for managing a cooling system in a data center. For example, a system comprises: a first heat exchanger (e.g., a cascade plate heat exchanger); a second heat exchanger (e.g., a small cascade heat exchanger), comprising an evaporator side and a condenser side, and connected to the first heat exchanger; a compressor, connected to the second heat exchanger and to the first heat exchanger; an evaporator, connected to a condenser and to the first heat exchanger; the condenser; a pump configured to cause refrigerant to flow between the evaporator and the condenser side of the second heat exchanger; a first fluid transfer valve, located in between a first side of the condenser and the condenser side of the second heat exchanger; a second fluid transfer valve, located in between the condenser side of the second heat exchanger and a second side of the condenser; and a third fluid transfer valve, located in between the condenser side of the second heat exchanger and the pump.

In another example, a system comprises: a first heat exchanger; a second heat exchanger, comprising an evaporator side and a condenser side, and connected to the first heat exchanger; a compressor, connected to the second heat exchanger and to the first heat exchanger; an evaporator, connected to a condenser and to the first heat exchanger; the condenser; a pump configured to cause refrigerant to flow between the evaporator and the condenser side of the second heat exchanger; a first fluid transfer valve, located in between the pump and the condenser side of the second heat exchanger; a second fluid transfer valve, located in between the condenser side of the second heat exchanger, a condenser side of the first heat exchanger, a first side of the condenser, and the evaporator; and a third fluid transfer valve, located in between the condenser side of the second heat exchanger and the first side of the condenser.

In another example, a system comprises: a first heat exchanger; a second heat exchanger, comprising an evaporator side and a condenser side, and connected to the first heat exchanger, to a first condenser, and to a second condenser; a compressor, connected to the second heat exchanger and to the first heat exchanger; an evaporator, connected to the condenser side of the second heat exchanger; the first condenser; the second condenser; a pump configured to cause refrigerant to flow between the evaporator and the condenser side of the second heat exchanger; a first fluid transfer valve, located in between a first side of the first condenser and the condenser side of the second heat exchanger; a second fluid transfer valve, located in between the condenser side of the second heat exchanger and a second side of the first condenser; and a third fluid transfer valve, located in between the condenser side of the second heat exchanger and the pump.

### BRIEF DESCRIPTION OF THE DRAWINGS

The disclosure is best understood from the following detailed description when read in conjunction with the accompanying drawings. It is emphasized that, according to common practice, the various features of the drawings are not to-scale. On the contrary, the dimensions of the various features are arbitrarily expanded or reduced for clarity.
FIG. 1 is a high-level illustration of components of a refrigerant management system within a data center environment, according to some examples.
FIG. 2 is a second high-level illustration of moving refrigerant between an isolated refrigerant storage unit to a primary circulation loop within a data center environment, according to some examples.
FIG. 3 is a first schematic diagram of a pumped refrigerant loop while operating in hot mode, according to some examples.
FIG. 4A is a second schematic diagram of a pumped refrigerant loop while operating in hot mode, according to some examples.
FIG. 4B illustrates operation of the pumped refrigerant loop, introduced in FIG. 4A, at a first moment in time after a request for additional charge in the pumped refrigerant loop has been made, according to some examples.
FIG. 4C illustrates operation of the pumped refrigerant loop, introduced in FIG. 4A, at a second moment in time after a request for additional charge in the pumped refrigerant loop has been made, according to some examples.
FIG. 4D illustrates operation of the pumped refrigerant loop, introduced in FIG. 4A, at a third moment in time after a request for additional charge in the pumped refrigerant loop has been made, according to some examples.
FIG. 5 is a flow diagram that illustrates a control algorithm that is executed by a computing device in order to manage operation of a pumped refrigerant loop within a data center, according to some examples.
FIG. 6A is a third schematic diagram of a pumped refrigerant loop while operating in hot mode, according to some examples.
FIG. 6B illustrates operation of the pumped refrigerant loop, introduced in FIG. 6A, at a first moment in time after a request for additional charge in the pumped refrigerant loop has been made, according to some examples.
FIG. 6C illustrates operation of the pumped refrigerant loop, introduced in FIG. 6A, at a second moment in time after a request for additional charge in the pumped refrigerant loop has been made, according to some examples.
FIG. 6D illustrates operation of the pumped refrigerant loop, introduced in FIG. 6A, at a third moment in time after a request for additional charge in the pumped refrigerant loop has been made, according to some examples.
FIG. 7A is a fourth schematic diagram of a pumped refrigerant loop while operating in hot mode, according to some examples.
FIG. 7B illustrates operation of the pumped refrigerant loop, introduced in FIG. 7A, at a first moment in time, when charge is trapped in a small heat exchanger, according to some examples.
FIG. 7C illustrates operation of the pumped refrigerant loop, introduced in FIG. 7A, at a second moment in time, after pressurization has occurred, according to some examples.
FIG. 8 illustrates a fifth schematic diagram of a pumped refrigerant loop while operating in hot mode, according to some examples.

### DETAILED DESCRIPTION

Reference will now be made in detail to examples which are illustrated in the accompanying drawings, wherein like reference numerals refer to like elements throughout. In this regard, the examples may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these examples that are obvious to those of ordinary skill in the technical field to which these examples pertain may not be described herein in detail.

It may be understood that the examples described herein may be considered in a descriptive sense only and not for purposes of limitation. Descriptions of features within each example may be considered as available for other similar features in other examples.

The present disclosure pertains to methods for enabling high sink temperatures while keeping a compressor within operating range for a data center environment. A cooling system within a data center environment that uses a compressed system to provide efficient and effective cooling to processors, computing devices, servers within server racks, and to any other IT equipment within a data center may be limited to heat sources that cause the compressed system's saturation temperatures to exceed component limitations. Thus, the present disclosure provides methods for moving refrigerant from a storage space, such as an isolated heat exchanger (HX) within a refrigerant-based cooling module (e.g., a neXt generation Direct Expansion (XDE) pumped system), to a flow loop, otherwise referred to herein as a circuit.

As related to examples described herein, "charge" may refer to refrigerant, or any other liquid media used within the cooling system, and "circuit," refers to a flow of the refrigerant within the data center environment. A given data center environment may comprise multiple circuits, according to some examples.

Methods and systems described herein for moving refrigerant from a storage space to a flow loop are configured to allow for bi-directional flow to and from the storage space. For example, in a two-phase evaporator, such as that which is used within a pumped system for an air handling unit (AHU), charge for a corresponding heat exchanger is fixed for a given superheat setting and capacity. When charge is then adjusted within the corresponding circuit, a condenser, such as a plate heat exchanger (PHE) or air cooling coils, is then affected by this change in charge. Moreover, a change in charge adds or reduces heat exchanger space in two-phase condensing, thus affecting system pressure and saturation temperature within a pumped loop defined by a refrigeration system with at least an evaporator and a condenser. Such a change in charge also affects a minimum required temperature difference needed between two fluids in order to move a given amount of heat.

As referred to herein, "superheat" and "subcool" may be defined as a number of degrees of temperature above or below, respectively, a saturation temperature at a given saturation pressure value.

By actively controlling charge within a pumped circuit in a data center environment to safeguard a cascade compressed system and fine-tune performance using methods and systems described herein, the already reserved storage of charge in economization heat exchangers and piping thus eliminates a need to incorporate a charge reserve tank (e.g., receiver) into the circuit. Moreover, the methods described herein apply the use of a pumped refrigerant or thermosyphon system. As used herein, an "economization heat exchanger" refers to a heat exchanger device, such as a plate heat exchanger, that recovers waste heat to be reused in the closed loop system. Such a definition may further extend to air-to-refrigerant rejection condenser coils that are being used to remove heat from the system when in economization mode, wherein no compressors are operating. This is in contrast to previous implementations which attempt to apply compressed condenser coils for such a purpose.

Furthermore, examples described herein apply a control method, such that a pumped cascade system is ready for increasing return air temperature (RAT), high processor temperatures during high-performance computing (HPC) loads operating at any given time within the data center environment, and any other extreme conditions that thus allow the circuits described herein to operate as though they were chill water systems, wherein there is no mechanical risk due to a high RAT.

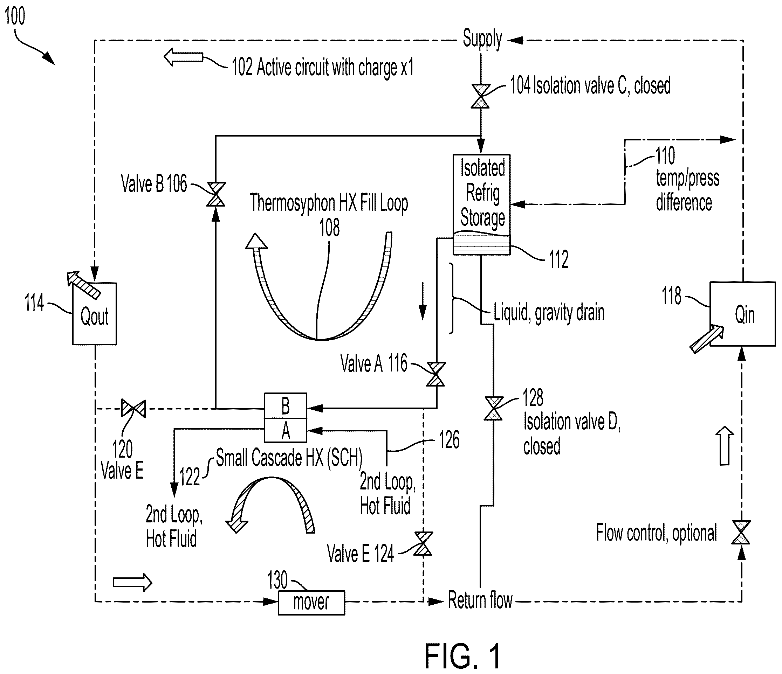

FIG. 1 is a high-level illustration of components of a refrigerant management system within a data center environment, according to some examples.

FIG. 1 illustrates a closed loop storage system wherein conditions of the closed loop are mainly dependent upon ambient air temperature. In such cases, it may be unreliable to condition the system upon a stored fluid within isolated refrigerant storage space 112 for power free movement. As indicated by temperature/pressure difference 110, a temperature and/or pressure difference between the isolated refrigerant storage 112 and the corresponding circuit loop utilizes at least a minimum difference in order to function. When ambient air temperature triggers enough of a temperature/pressure difference 110, then the isolated refrigerant storage space 112 may act as an air refrigerant heat exchanger. However, when ambient air temperature does not trigger enough of a temperature/pressure difference 110, the following examples are applied in order to ensure refrigerant circulation within system 100.

In some examples, some type of fluid may circulate within a heat transfer system of the overall system 100 shown in FIG. 1. This may also be referred to herein as a "primary" or "active" circuit, wherein the active circuit is denoted by arrows flowing between *Qₒᵤₜ* 114 and *Qᵢₙ* 118 in the figure. Moreover, no flow of fluid may occur between isolation valve C 104 and isolation valve D 128, which are denoted as closed in the figure, since fluid has been contained there.

During a typical operation of the system 100, precise charge within the active circuit is regulated relative to operating conditions of the system 100.

For ease of discussion herein, FIG. 1 illustrates, via arrow 102, that there is some amount of charge, *x*₁, within the active loop that enables some amount of cooling *q*₁ at *Qᵢₙ* 118. When an amount of charge at *Qᵢₙ* 118 increases or decreases, charge within the active loop changes as well by ±*x*₁. In general, a small variance of charge at *Qᵢₙ* 118 is within tolerance. However, when an amount of charge at *Qᵢₙ* 118 drastically increases or decreases, an amount of charge in the active loop changes. In addition, ambient air temperature may also impact the amount of charge to be pushed through the active circuit. For example, seasonal ambient air temperatures in winter vs. summer. Moreover, supply temperature settings may impact charge requirements.

As many variables may impact the ability to rely on temperature/pressure difference 110 to provide a consistent and constant rate of refrigerant flow within the active circuit, charge inside an isolated section of system 100 may be additionally relied upon to make up a difference or to absorb excess refrigerant.

In some examples, a secondary, isolated circuit within the system 100 may refer to a loop between the isolated refrigerant storage space 112, a valve A 116, a small cascade heat exchanger (SCH) 122, a valve B 106, and a second loop hot fluid 126. The small cascade heat exchanger 122 may be implemented as a brazed plate heat exchanger (BPHE), a shell-tube heat exchanger, or some similar type of model.

In some examples, when the ambient air temperature is lower than the active loop's saturation temperature, a method of raising the pressure in the isolated refrigerant storage space 112 is applied in order to move refrigerant fluid from the isolated refrigerant storage space 112 into circulation within the active loop. In some examples, a pump may be installed within the system 100 in order to fulfill this need. However, at some moments in time, ambient air temperature may be cold enough such that a highest head capable pumps would be installed in order to fulfill that need. In some examples, the placement of the small cascade heat exchanger 122 on a hot side of the second loop hot fluid 126 enables for trapped liquid is increased and becomes approximately equal to or higher than the liquid in the circuit that the charge is being transferred to.

In some examples, a volume of fluid that may be stored within the small cascade heat exchanger 122 is orders of magnitude larger than piping on either side. Thus, the secondary, isolated circuit shown in the system 100 acts as a heat source, with the internal volume of the small cascade heat exchanger 122 being dependent upon the size of the active circuit of the system 100.

FIG. 1 further illustrates that the valve A 116, valve B 106, valve E 120, and valve E 124 are controlled such that the volume of fluid within the small cascade heat exchanger 122 is maintained using fluid from the isolated refrigerant storage space 112 or the active loop of system 100. Moreover, valve A 116, valve B 106, valve E 120, and valve E 124 may further be controlled into opened or closed positions again to trap charge that is moved to and from the isolated refrigerant storage space 112.

Valve A 116, valve B 106, valve E 120, and valve E 124 may respectively refer to fluid transfer valves. Moreover, valve E 120 and valve E 124 are meant to illustrate different placement options for a single valve E, according to different examples. For example, the valve E 120 may be placed at mover 130 inlet, wherein mover 130 may resemble a pump, compressor, or other means of moving charge. In another example, valve E 124 may be placed at a liquid line after the mover 130. In yet other examples, a valve E may be placed at a vapor line. The placement of the single valve E, such as at the locations illustrated by valve E 120 and valve E 124, impact a difference pressure ratio 110 and a mass of the charge moved back and forth across the active loop, according to some examples.

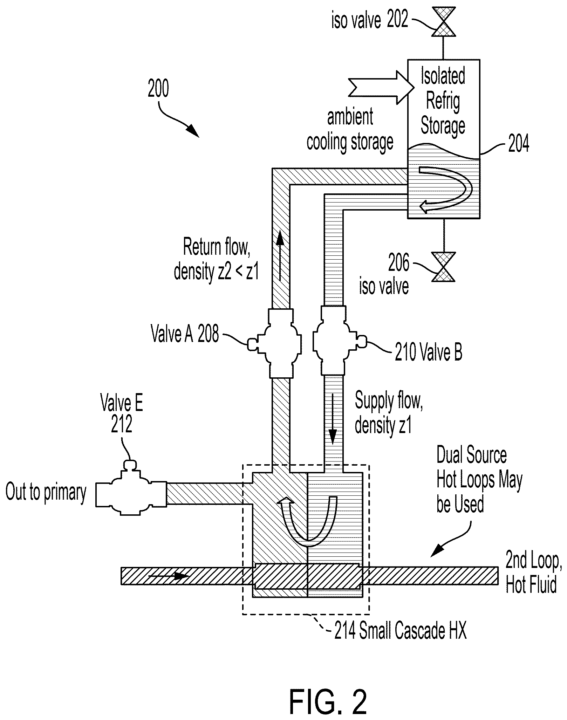

As additionally illustrated in FIG. 1, a thermosyphon heat exchanger fill loop 108, which includes the isolated refrigerant storage space 112, valve A 116, the small cascade heat exchanger 122, and valve B 106, is configured to maintain a volume of fluid in isolated refrigerant storage space 112. The incorporation of the thermosyphon heat exchanger fill loop 108 prevents vapor pockets within the secondary circuit, which would otherwise risk warming the stagnated fluid quickly to a temperature above the local saturation pressure and preventing a complete fluid fill and pressurization. Such examples are additionally described with regard to FIG. 2 below.

"Return flow" and "supply" in FIG. 1 represent the placements of liquid inlets and outlets for examples of the system 100 that are implemented for two-phase circuits.

FIG. 2 is a second high-level illustration of moving refrigerant between an isolated refrigerant storage unit to a primary circulation loop within a data center environment, according to some examples.

A system 200 illustrates the secondary circuit introduced with regard to the system 100 of FIG. 1. As shown in FIG. 2, the secondary circuit is configured to move charge from an isolated refrigerant storage space 204 to the active loop (not shown in FIG. 2, but denoted by "out to primary" at Valve E 212).

Particular examples shown in FIG. 2 resemble a moment in time in which ambient air temperature is low. Thus, a supply flow with density *z*₁ flows from the isolated refrigerant storage space 204, through Valve B 210, and into the small cascade heat exchanger 214. A return flow with a density *z*₂, which is less than density *z*₁, flows from the small cascade heat exchanger 214, through valve A 208, and into the isolated refrigerant storage space 204.

When filling, the supply and return flows are greater than zero. When pressurizing, the supply and return flows are approximately equal to zero. When pressure or temperature (see also temperature/pressure difference 110 in FIG. 1) is at target, discharge flow is greater than zero, and valve E 212 is controlled into an opened position.

Similarly to those which were introduced in FIG. 1, valve A 208, valve B 210, and valve E 212 may respectively refer to fluid transfer valves, and isolation valves 202 and 206 restrict fluid flow into and out of the isolated refrigerant storage space 204. Moreover, particular examples illustrated in FIG. 2 resemble a placement of valve E 212 at a mover inlet.

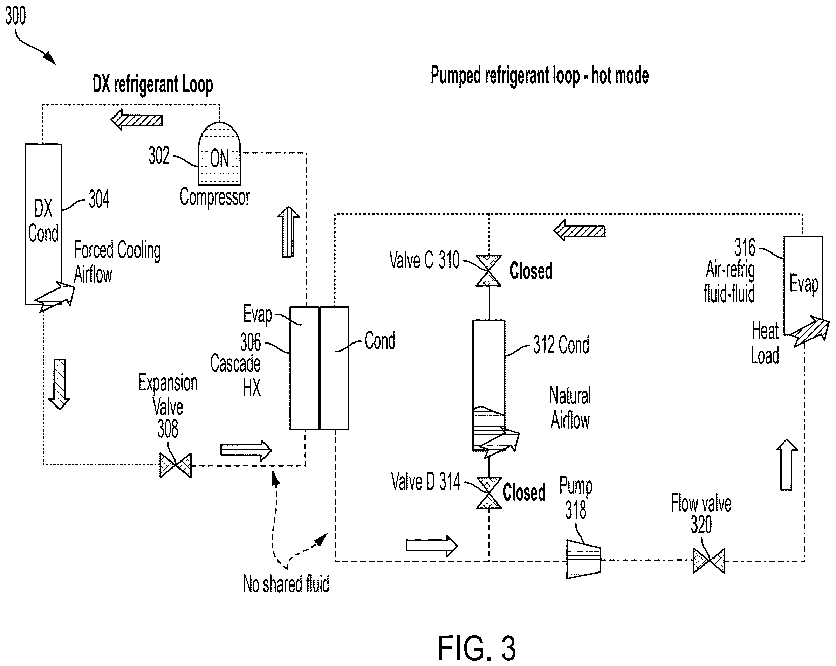

FIG. 3 is a first schematic diagram of a pumped refrigerant loop while operating in hot mode, according to some examples.

As shown in FIG. 3, a system 300 is configured to operate with two separate loops that share no fluid. At a moment in time depicted in FIG. 3, the system 300 is operating in hot mode, such that DX operation is triggered and low ambient coils are isolated. As used herein, "DX" of DX condenser 304 refers to direct expansion, and to a compressed refrigerant system for direct expansion at the evaporator of a cascade heat exchanger 306.

A hot fluid from pumped evaporator 316 flows through the condensing side of the cascade heat exchanger 306. In some examples, the cascade heat exchanger 306 may resemble a plate heat exchanger (PHE), a brazed plate heat exchanger (BPHX), a brazed plate heat exchanger (BPHE), a plate heat exchanger (PHX), a plate fin, or any other liquid-liquid or fluid-fluid heat exchanger, such as a shell and tube, a double pipe, or a compact heat exchanger.

In some examples, such as during standard cooling procedures, valve C 310 and valve D 314 remain open. When ambient air temperature is high or is excessively cold, however, valve C 310 and valve D 314 are closed in order to trap any refrigerant inside the condenser 312 space, such that heat exchanger and piping trap the refrigerant. Unused charge is stored between valve C 310 and valve D 314 within system 300, not in the active loop, and in order to trap the charge, refrigerant, or other medium in a closed space. The condenser 312 and piping acts as an isolated storage tank. A pump 318 is located in between the condenser 312 and the evaporator 316.

Moreover, illustrations of valve C 310 and valve D 314 resemble single valves for ease of discussion herein. However, there may be a valve C and a valve D for each set of condenser coils, according to some examples.

In some examples in which ambient air temperature is high, cooling of the pumped refrigerant cooling loop, depicted by a cascade heat exchanger 306, a compressor 302, the DX condenser 304, and an expansion valve 308, is conducted via the cascade heat exchanger 306.

In some examples in which ambient air temperature is low, some of the condenser coils are closed, in order to reserve pressure within the refrigerant loop above a minimum point.

For low ambient conditions, some of the condenser coils are closed, this is to help reserve pressure within the refrigerant loop above a minimum point.

Moreover, a flow valve 320 may cause refrigerant to change phase and to expand.

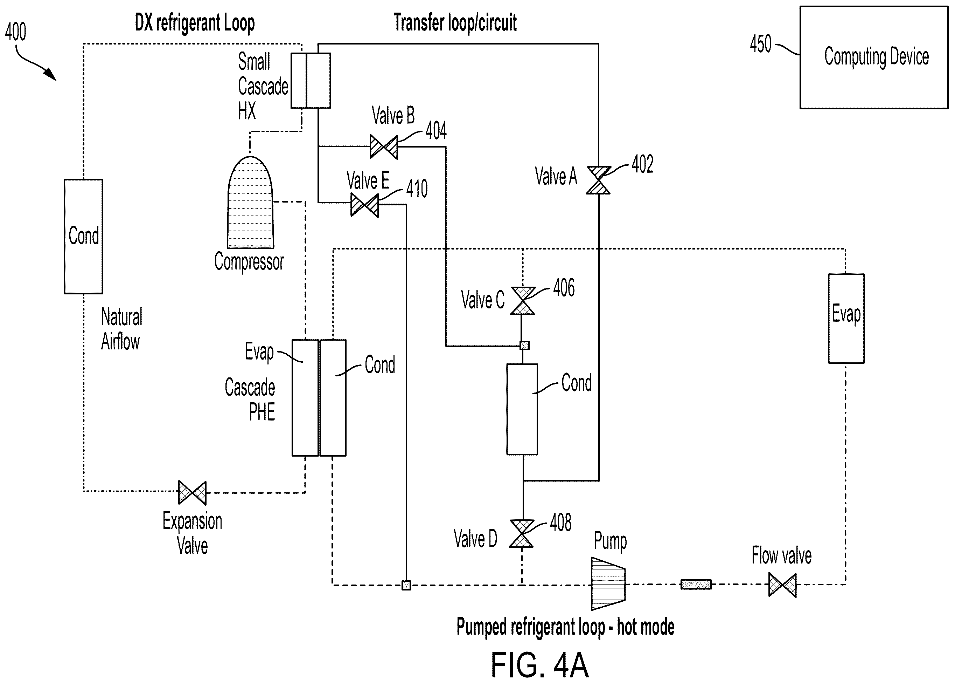

FIG. 4A is a second schematic diagram of a pumped refrigerant loop while operating in hot mode, according to some examples.

A system 400 illustrates a moment in time in which ambient air is cooling refrigerant trapped between valve C 406 and valve D 408, such that pressure is below an operating pressure for the pumped loop. In order to transfer refrigerant mass from storage to the pumped loop, pressure is raised.

The system 400 is configured such that transfer of charge occurs under any condition, e.g., either differential pressure direction. Thus, the transfer circuit is bi-directional.

As illustrated in the system 400, valve A 402 is actuated, and is an inlet when storage pressure is low. Valve B 404 is actuated, and is a flushing valve used in conjunction with valve A 402. Valve C 406 is actuated, and is a relief valve for flow into the pumped loop. Moreover, the cascade heat exchanger, shown in FIG. 4A, may resemble a plate heat exchanger, a plate fin heat exchanger, or any other similar model, such as the other liquid-liquid or fluid-fluid heat exchangers described above (e.g., a shell and tube, a double pipe, or a compact heat exchanger), for pressurizing the transfer loop and generating thermosyphon motion.

Moreover, valve A 402 and valve B 404 are configured to allow a flow of fluid into the trapped space between valve C 406 and valve D 408 through convection flow. The fluid is thus configured to flow quickly, e.g., before heating enough to change phase into vapor and fill the entire trapped space, including the small cascade heat exchanger with liquid refrigerant.

The system 400 is configured such that two valves enable a one directional transfer.

When the system 400 is in hot mode, the economization condensers are closed and used for storage.

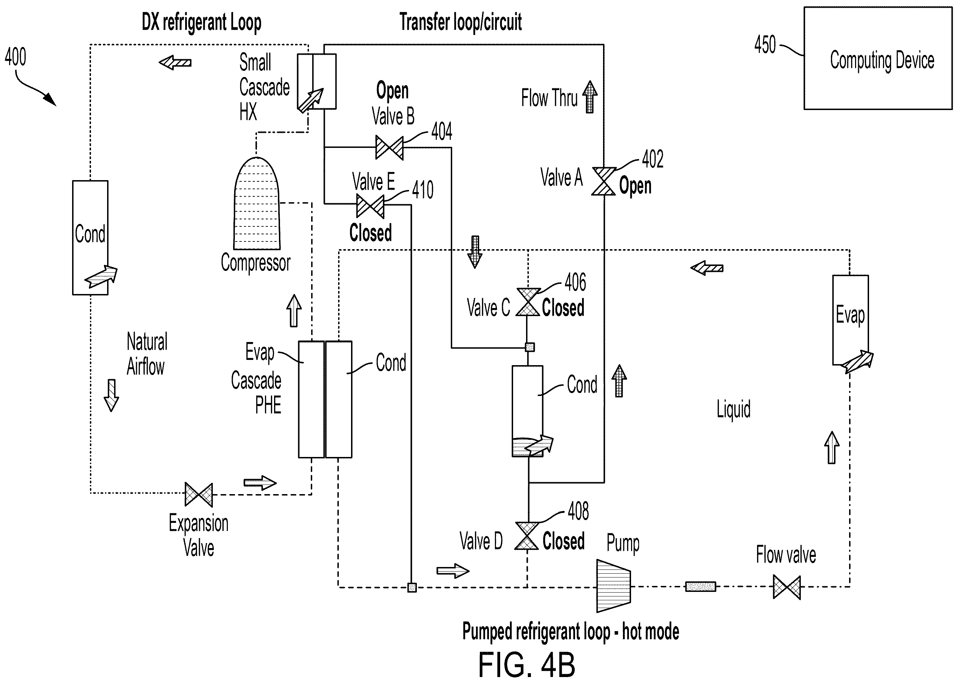

FIG. 4B illustrates operation of the pumped refrigerant loop, introduced in FIG. 4A, at a first moment in time after a request for additional charge in the pumped refrigerant loop has been made, according to some examples.

When a request is made for additional charge in the active pumped circuit of the system 400, ambient air temperature is such that pressure between valve C 406 and valve D 408 is less than that within the active pumped refrigerant loop. Valve A 402 and valve B 404 are then set to an opened position to allow volume of fluid between valve A 402 and valve B 404, including the heat exchanger volume, to fill with liquid. When full, valve A 402 and valve B 404 are set to the closed position.

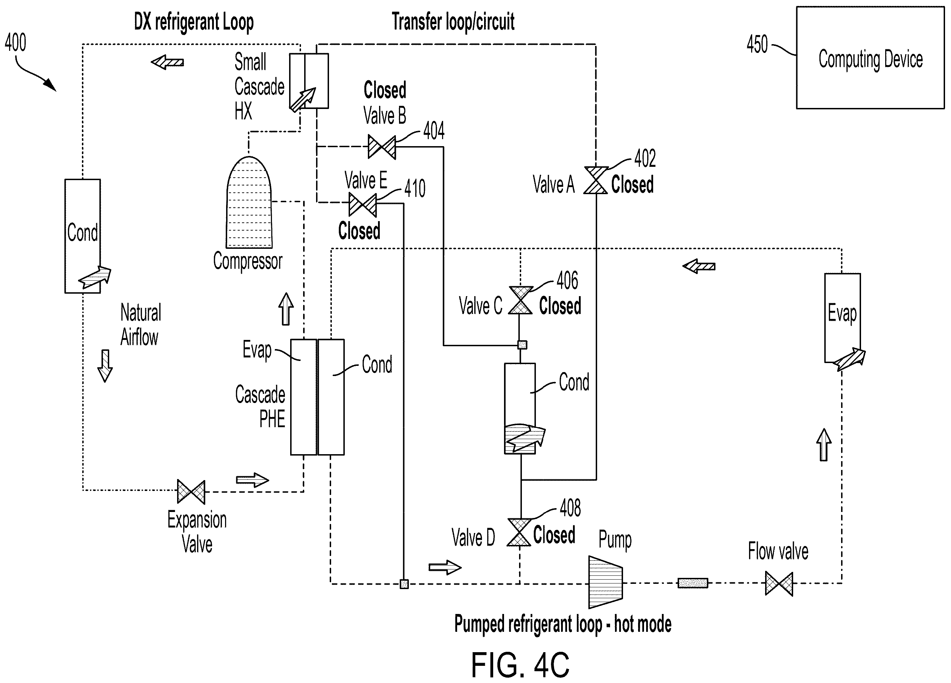

FIG. 4C illustrates operation of the pumped refrigerant loop, introduced in FIG. 4A, at a second moment in time after a request for additional charge in the pumped refrigerant loop has been made, according to some examples.

When ambient air temperature is such that pressure between valve C 406 and valve D 408 is less than the active pumped refrigerant loop, and with valve A 402 and valve B 404 set to a closed position, heat from the small cascade heat exchanger heats and raises the pressure within the closed volume between valves A 402, B 404, and E 410.

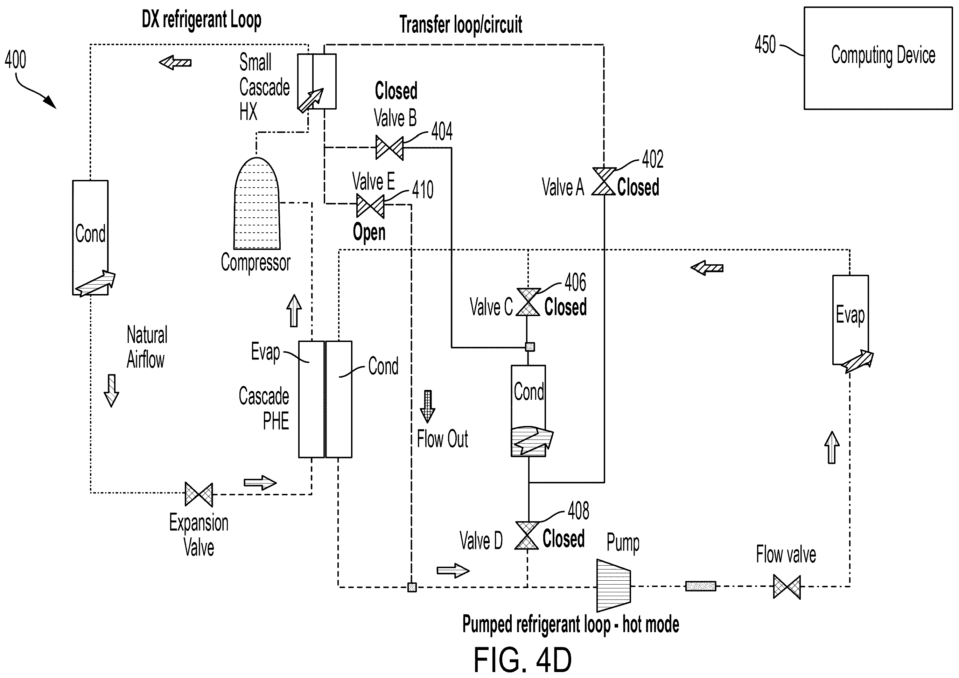

FIG. 4D illustrates operation of the pumped refrigerant loop, introduced in FIG. 4A, at a third moment in time after a request for additional charge in the pumped refrigerant loop has been made, according to some examples.

When ambient air temperature is such that pressure between Valves C 406 and D 408 is less than the active pumped refrigerant loop, and when the refrigerant pressure between valves A 402, B 404, and E 410 is sufficiently above the active pumped loop's pressure, valve E 410 is set to an opened position to allow charge to flow.

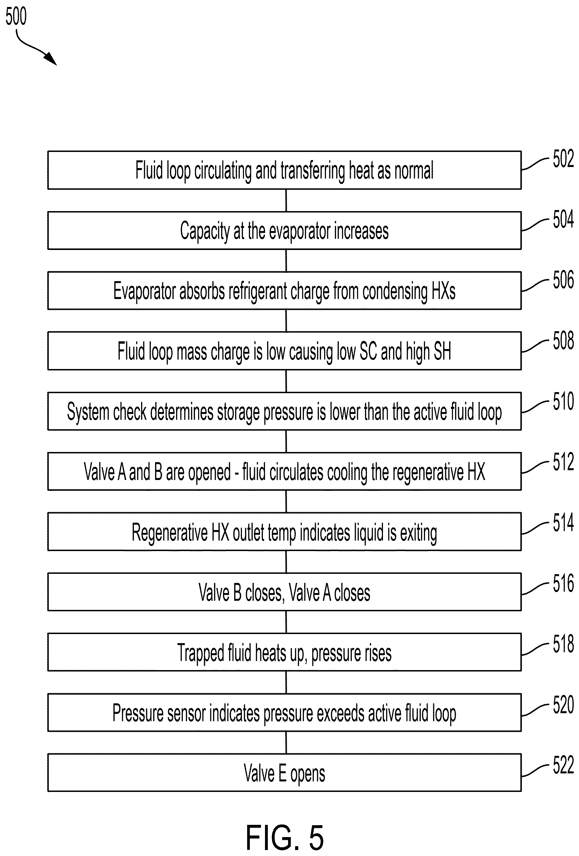

FIG. 5 is a flow diagram that illustrates a control algorithm that is executed by a computing device in order to manage operation of a pumped refrigerant loop within a data center, according to some examples.

Process 500 describes a method for moving charge from a lower pressure to a higher pressure space within the schematics shown in FIGS. 1, 2, 3, 4A - 4D, 6A - 6D, 7A - 7C, and 8 herein. Moreover, controlling of valve positions, e.g., wherein a valve position is closed, partially opened, or fully opened, is managed by computing device 450 for system 400, by computing device 650 for system 600, by computing device 750 for system 700, and by computing device 850 for system 800. The respective computing device may generate and then provide instructions to a processor located within or proximate to the valve, wherein the instructions cause the valve to be opened further with respect to the valve position that the valve had previously, or cause the valve to be closed further with respect to the valve position that the valve had previously.

The controls performed within a process 500 adjust charge in the pumped loop. When evaporation, or loads, are at a stable operating condition (e.g., with adequate vapor and superheat conditions and adequate liquid and subcool conditions within two-phase and liquid regions of the evaporators and condensers) for each load, the liquid stored at the condensing side of the cascade plate heat exchanger will change. The charge changes in the loop will change the efficiency of the heat exchanger where the change settles, either at the approach or gap temperature. This enables for a high return air temperature and/or fluid temperature at the pumped loop load by decreasing condensing space at the plate heat exchanger, effectively making the plate heat exchanger smaller. Then, correct or adjust a subcool condition into the pump.

As used herein, an "approach" or "gap" temperature refers to a difference between saturation temperatures of the evaporation and condensation sides of the cascade heat exchanger, respectively. For example, adding charge to the condensing side of the cascade heat exchanger will then change the temperature relationship between the evaporation and condensation sides that enables the transfer of heat.

When in hot mode, extra charge may be utilized for economization mode, which is stored between valves C and D, which includes manifolds, condenser coils, and piping.

If charge is needed in the hot mode loop, the storage space needs to provide refrigerant or take refrigerant. Moreover, ambient air temperatures determine if this can naturally be accomplished or if work must be done on the refrigerant.

If ambient is greater than pumped loop saturation temperature, refrigerant cannot be pushed into the storage space, and the pressure of the operating refrigerant loop would have to be raised. A high pressure pump can be used, a high cost, or this process 500 may be used, raising a small volume to a higher pressure.

The operating loop's pump could potentially provide the means to move charge into storage. At high ambient temps, the operating loop would either have to reduce capacity/flow at the loads or have an oversized pump. Reducing flow at the load back pressures the pump allowing a high difference in pressure, dP, to develop. However, most pumps used for this function (refrigerant flow) are not capable to go from 70°F saturation to over 105°F saturation (when air temps are 105°F), thus requiring saturation in the operating loop to rise which will in turn raise supply air temperature or outlet load fluid during this action.

If ambient is lower than the pumped loop saturation temperature and charge is needed in the hot mode loop (operating loop that does not include the storage space), charge from the stored space must have the pressure raised to move the charge. A pump is not cost effective for this occasional use.

The heat (kWs) from the operating compressor circuit can be used as the work required to raise the pressure and move charge either direction. Trapped charge between two valves or a group of valves will be heat which raises pressure proportionally. The charge is released either one or more valves to the loop that needed more charge. This small cascade heat exchanger is a low capacity design for two isolated flowing fluids however, when the cold fluid is stagnant, stopped by two valves or more, the temperature will rise quickly, mass flow is zero so just a mass based absorption. For refrigerant, the specific heat is low.

The pressurization heat exchanger will hold a warm temperature between valves A and B when not used. This requires cooling or a bypass to allow filling to happen for a typical HX. Special operation of valves A and B are required when not used. For example, if valve B is held open, then the pressure from valve A to valve B will be at ambient storage pressure even if the refrigerant between valve A and valve B is high or vapor if storage is at a cooler ambient.

As shown in process 500, block 502 refers to fluid loop circulating and transferring heat at normal operating conditions.

As illustrated in block 504, capacity at the evaporator increases.

As illustrated in block 506, the evaporator absorbs refrigerant charge from the condensing heat exchanger.

As illustrated in block 508, fluid loop mass charge is low, causing low supercool and high superheat.

As illustrated in block 510, the computing device checks to determine that storage pressure is lower than the active fluid loop. In some examples, the storage pressure level may be monitored by a computing device, such as computing device 450, 650, 750, or 850. The pressure sensors that detect the storage pressure itself may be located within the storage space in between valves C and D.

As illustrated in block 512, valve A and Valve B are opened, and fluid circulates, cooling the regenerative head exchanger.

As illustrated in block 514, the regenerative heat exchanger outlet temperature indicates liquid is exiting. In some examples, the heat exchanger outlet temperature may be monitored by a computing device, such as computing device 450, 650, 750, or 850.

As illustrated in block 516, valve B is fixed to the closed position, and valve A is fixed to the closed position.

As illustrated in block 518, trapped fluid heats up, and pressure rises.

As illustrated in block 520, a pressure sensor indicates that pressure exceeds the active fluid loop. In some examples, pressure sensors that indicate such parameters may be located both between valves C and D (e.g., near the economization condenser), and within the active loop.

As illustrated in block 522, valve E is fixed to an opened position.

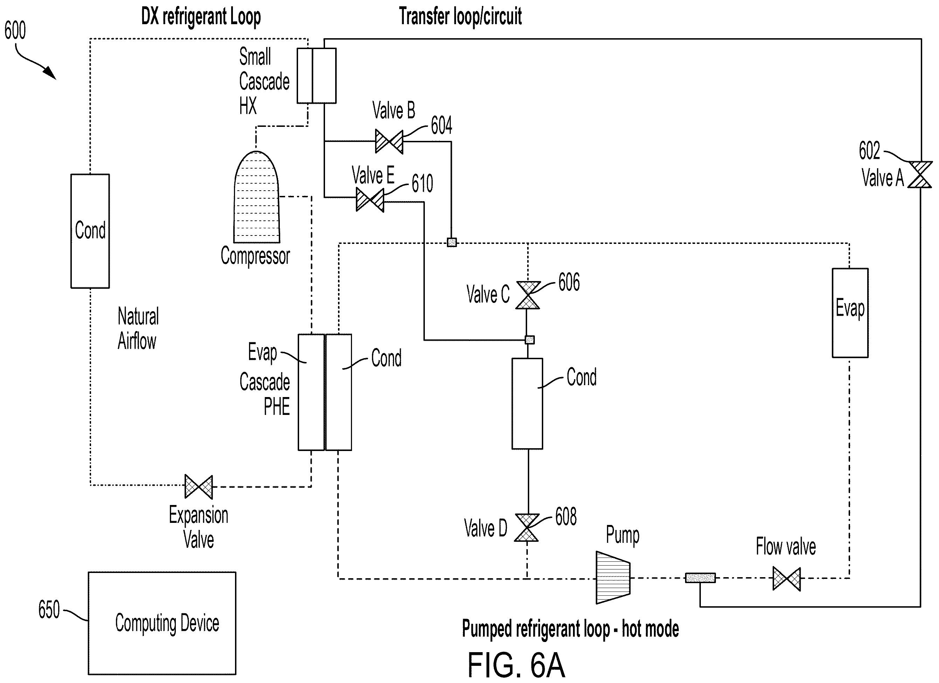

FIG. 6A is a third schematic diagram of a pumped refrigerant loop while operating in hot mode, according to some examples.

As shown in a system 600, refrigerant is transferred from the pumped refrigerant loop - hot mode to storage at a higher pressure due to a high ambient air temperature, at the particular moment in time depicted by the series of FIGS. 6A - 6D.

In FIG. 6A, valve A 602 is opened to push charge through valve B 604 and into the small cascade heat exchanger in order to pre-cool the small cascade heat exchanger. In some examples, a pre-cool process may resemble the following: the small cascade heat exchanger is initially warmed, which then causes refrigerant to boil. An available flow from valve A 602 through valve B 604 is then enabled in order to cool, or "pre-cool," the small cascade heat exchanger such that it may hold liquid.

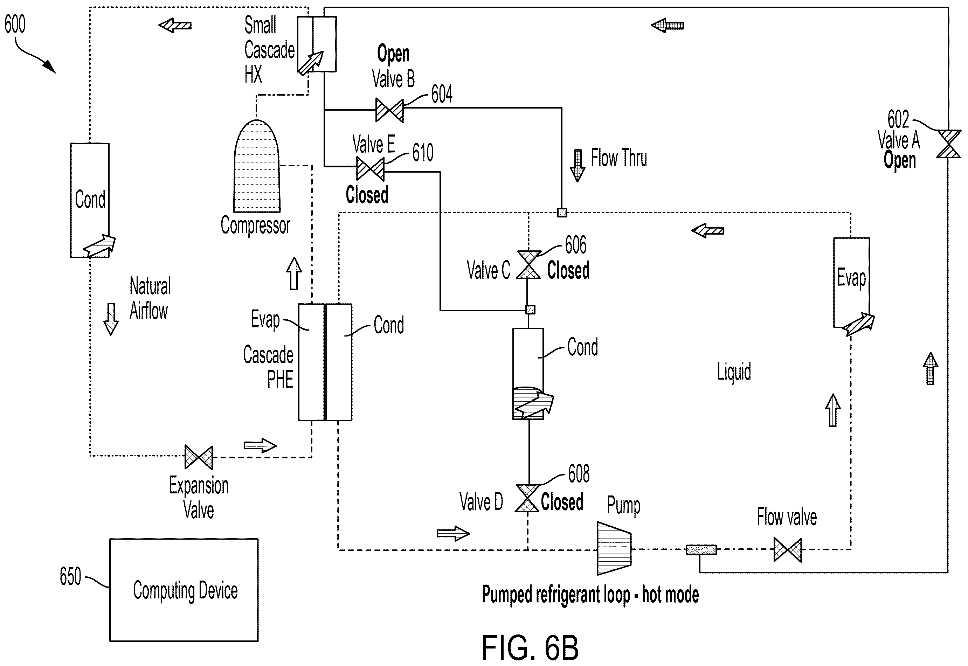

FIG. 6B illustrates operation of the pumped refrigerant loop, introduced in FIG. 6A, at a first moment in time after a request for additional charge in the pumped refrigerant loop has been made, according to some examples.

In FIG. 6B, valve B 604 is controlled into the closed position, followed by the closing of valve A 602.

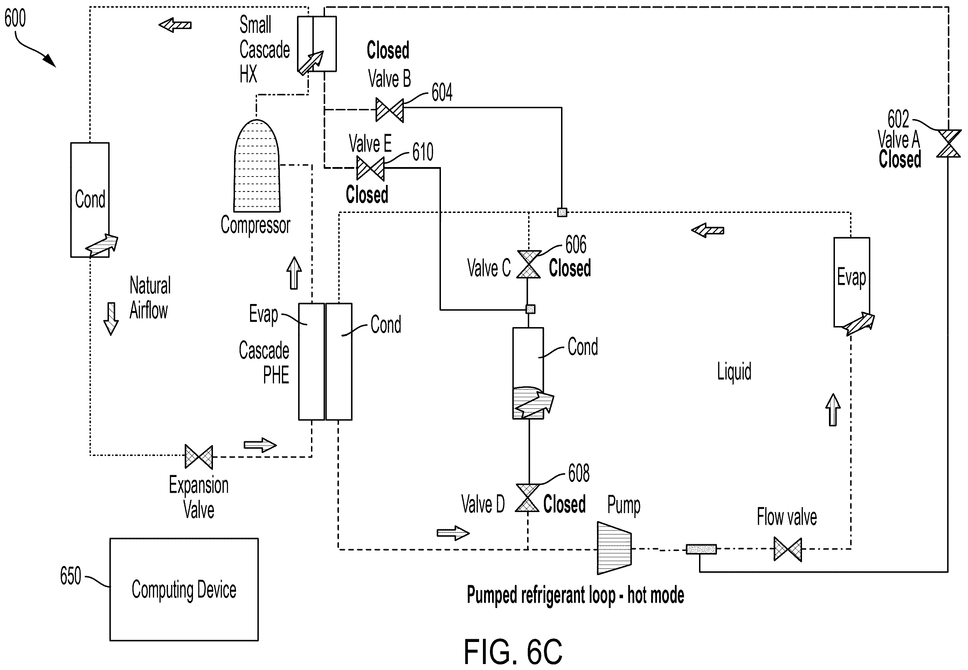

FIG. 6C illustrates operation of the pumped refrigerant loop, introduced in FIG. 6A, at a second moment in time after a request for additional charge in the pumped refrigerant loop has been made, according to some examples.

In FIG. 6C, the DX condenser discharge heat warms the charge and pressurizes the system 600.

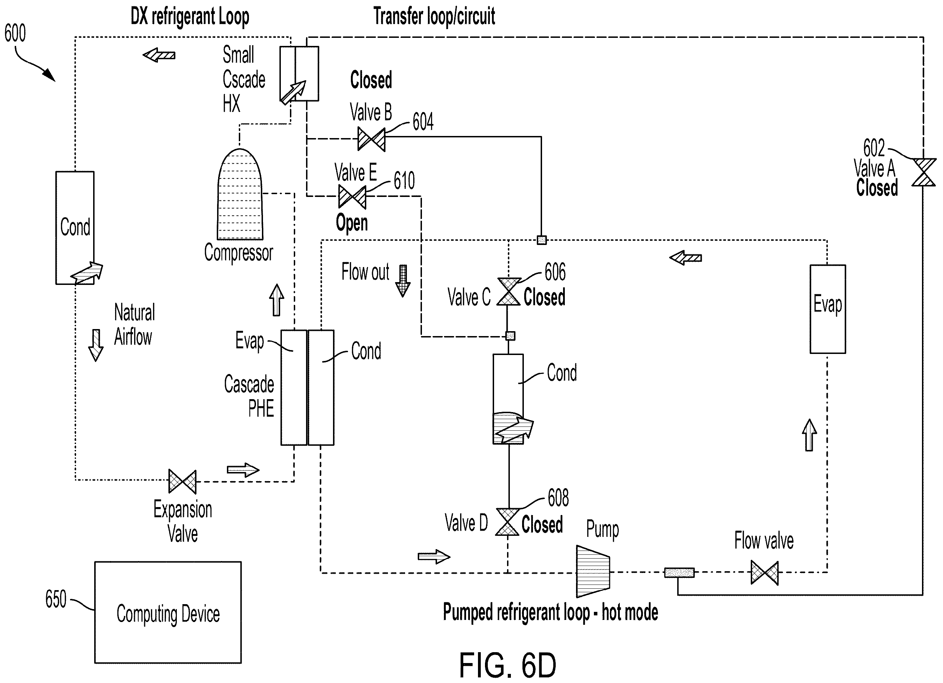

FIG. 6D illustrates operation of the pumped refrigerant loop, introduced in FIG. 6A, at a third moment in time after a request for additional charge in the pumped refrigerant loop has been made, according to some examples.

In FIG. 6D, valve E 610 is controlled into the open position in order to meet a target pressure, and fluid exits, leaving vapor.

Also illustrated in the system 600 are valve C 606 and valve D 608.

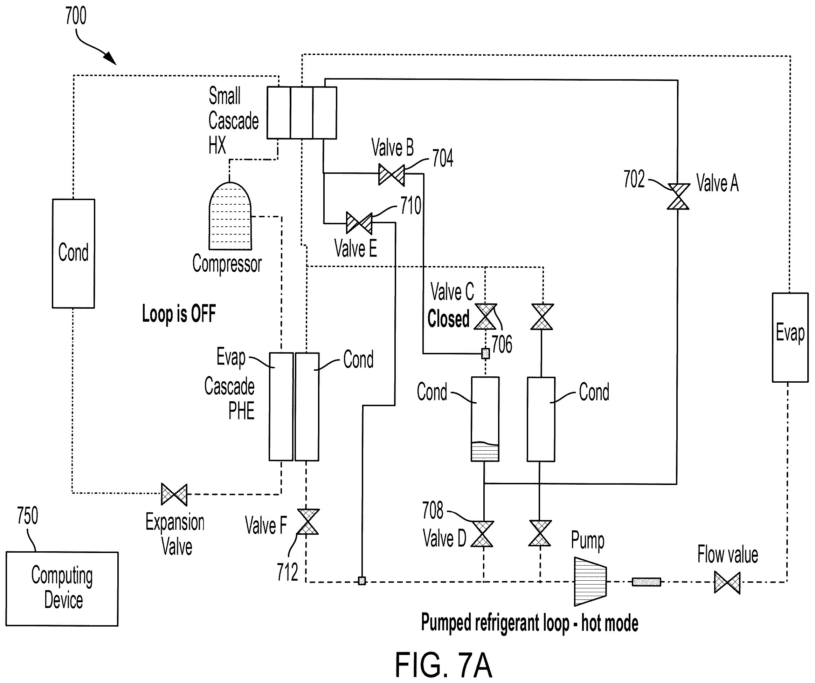

FIG. 7A is a fourth schematic diagram of a pumped refrigerant loop while operating in hot mode, according to some examples.

A system 700 depicts a refrigerant transfer from storage to pumped loop when the storage is at a low ambient air temperature and the active loop is in economization mode. At a moment in time depicted by FIG. 7A, a portion of the condenser heat exchanger is closed for split condensing, trapping extra refrigerant. As shown in the figure, the active loop can be a heating source for the small cascade regenerative heat exchanger.

Valve A 702 is fixed to an opened position, and charge is pushed into the heat exchanger volume through valve B 704 to pre-cool. Flow through valve A 702 and then valve B 704 is driven by the heat input and density change of the liquid refrigerant entering via valve A 702.

Valve B 704 is then fixed to a closed position, along with valve A 702.

DX discharge heat then warms the charge and pressurizes.

Valve E 710 is then fixed to an opened position at a target pressure, and fluid exits, leaving vapor.

Also illustrated in the system 700 are valve C 706, valve D 708, and valve F 712.

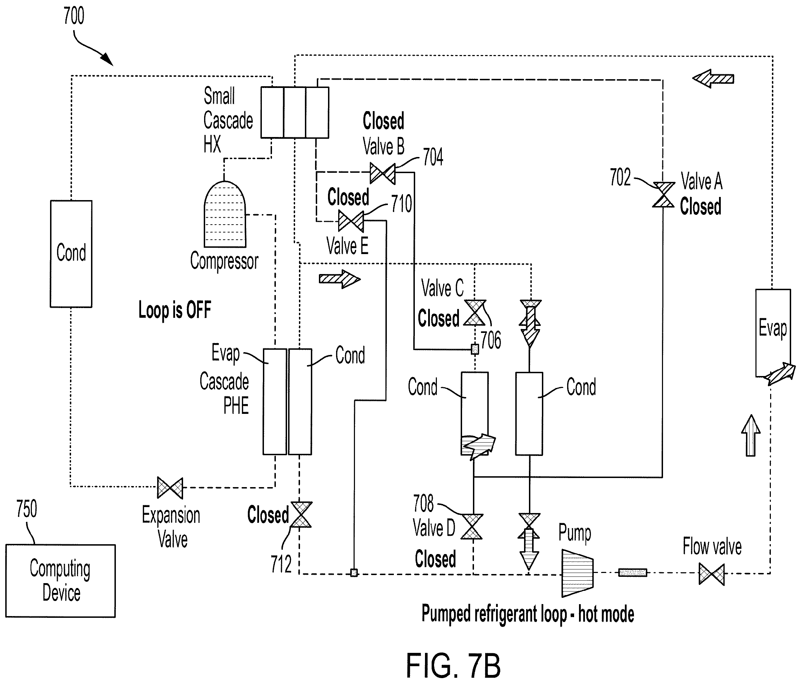

FIG. 7B illustrates operation of the pumped refrigerant loop, introduced in FIG. 7A, at a first moment in time, when charge is trapped in a small heat exchanger, according to some examples.

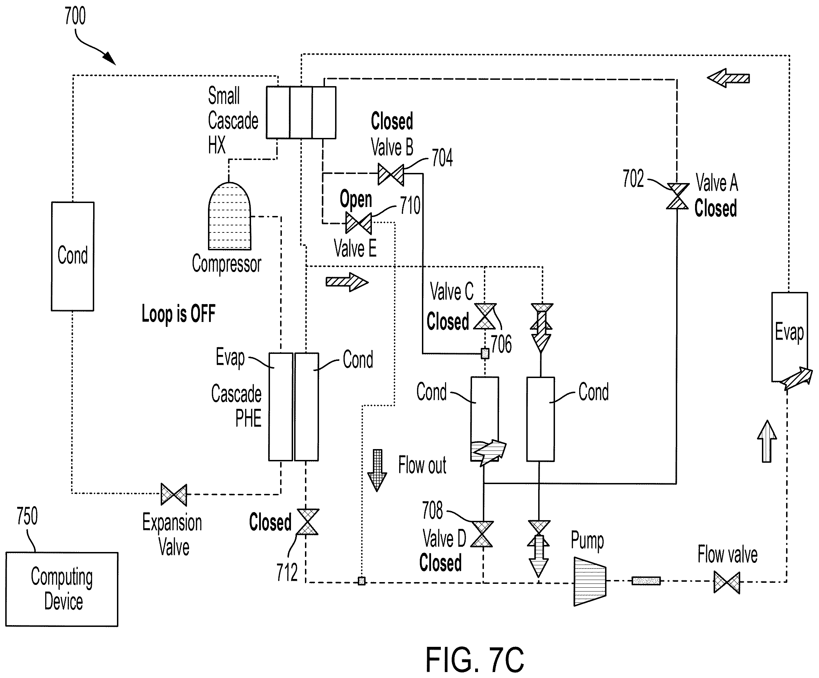

In FIG. 7B, charge is trapped in the small cascade heat exchanger, and is being heated, then pressurized in the illustration shown in FIG. 7C.

FIG. 7C illustrates operation of the pumped refrigerant loop, introduced in FIG. 7A, at a second moment in time, after pressurization has occurred, according to some examples.

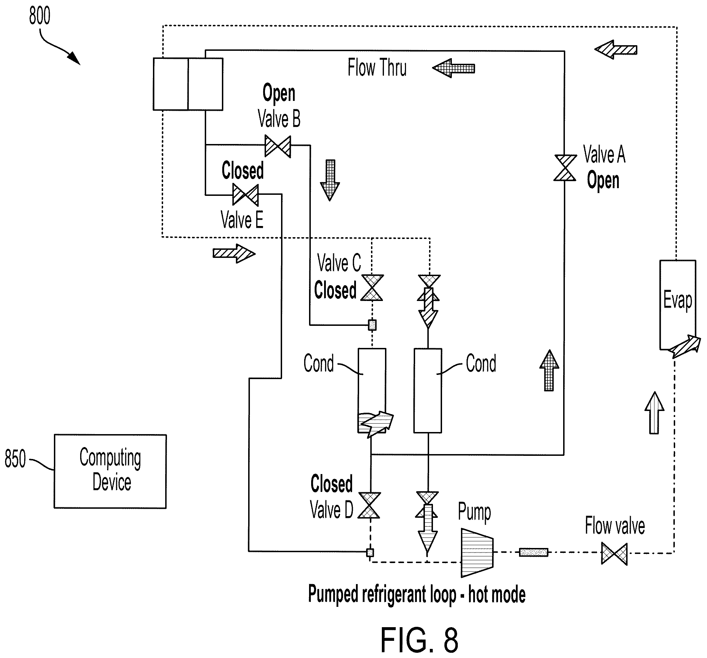

FIG. 8 illustrates a fifth schematic diagram of a pumped refrigerant loop, according to some examples. A system 800 depicts examples in which no compressor circuit is included within the system.

Further examples are set out in the clauses below:
1. A system, comprising:
   a first heat exchanger;
   a second heat exchanger, comprising an evaporator side and a condenser side, and connected to the first heat exchanger;
   a compressor, connected to the second heat exchanger and to the first heat exchanger;
   an evaporator, connected to a condenser and to the first heat exchanger;
   the condenser;
   a pump configured to cause refrigerant to flow between the evaporator and the condenser side of the second heat exchanger;
   a first fluid transfer valve, located in between a first side of the condenser and the condenser side of the second heat exchanger;
   a second fluid transfer valve, located in between the condenser side of the second heat exchanger and a second side of the condenser; and
   a third fluid transfer valve, located in between the condenser side of the second heat exchanger and the pump.
2. The system of clause 1, wherein the first, second, and third fluid transfer valves are configured to generate thermosyphon motion within the system.
3. The system of clause 1 or clause 2, further comprising a fourth fluid transfer valve, located in between a condenser side of the first heat exchanger, the evaporator, and the second side of the condenser.
4. The system of clause 1 or clause 2, further comprising a fourth fluid transfer valve, located in between the first side of the condenser and the pump.
5. The system of any one of clauses 1 to 4, wherein the first heat exchanger is implemented as a cascade plate heat exchanger.
6. The system of any one of clauses 1 to 4, wherein the second heat exchanger is implemented as a brazed plate heat exchanger.
7. The system of any one of clauses 1 to 5, wherein the second heat exchanger is implemented as a shell-tube heat exchanger.
8. A system, comprising:
   a first heat exchanger;
   a second heat exchanger, comprising an evaporator side and a condenser side, and connected to the first heat exchanger;
   a compressor, connected to the second heat exchanger and to the first heat exchanger;
   an evaporator, connected to a condenser and to the first heat exchanger;
   the condenser;
   a pump configured to cause refrigerant to flow between the evaporator and the condenser side of the second heat exchanger;
   a first fluid transfer valve, located in between the pump and the condenser side of the second heat exchanger;
   a second fluid transfer valve, located in between the condenser side of the second heat exchanger, a condenser side of the first heat exchanger, a first side of the condenser, and the evaporator; and
   a third fluid transfer valve, located in between the condenser side of the second heat exchanger and the first side of the condenser.
9. The system of clause 8, wherein the first, second, and third fluid transfer valves are configured to generate thermosyphon motion within the system.
10. The system of clause 8 or clause 9, further comprising a fourth fluid transfer valve, located in between the second fluid transfer valve and the first side of the condenser.
11. The system of clause 8 or clause 9, further comprising a fourth fluid transfer valve, located in between a second side of the condenser and the pump.
12. The system of any one of clauses 8 to 11, wherein the first heat exchanger is implemented as a cascade plate heat exchanger.
13. The system of any one of clauses 8 to 12, wherein the second heat exchanger is implemented as a small cascade heat exchanger.
14. A system, comprising:
   a first heat exchanger;
   a second heat exchanger, comprising an evaporator side and a condenser side, and connected to the first heat exchanger, to a first condenser, and to a second condenser;
   a compressor, connected to the second heat exchanger and to the first heat exchanger;
   an evaporator, connected to the condenser side of the second heat exchanger;
   the first condenser;
   the second condenser;
   a pump configured to cause refrigerant to flow between the evaporator and the condenser side of the second heat exchanger;
   a first fluid transfer valve, located in between a first side of the first condenser and the condenser side of the second heat exchanger;
   a second fluid transfer valve, located in between the condenser side of the second heat exchanger and a second side of the first condenser; and
   a third fluid transfer valve, located in between the condenser side of the second heat exchanger and the pump.
15. The system of clause 14, wherein the first, second, and third fluid transfer valves are configured to generate thermosyphon motion within the system.
16. The system of clause 14 or clause 15, further comprising a fourth fluid transfer valve, located in between the condenser side of the second heat exchanger, a condenser side of the first heat exchanger, and a second side of the first condenser.
17. The system of clause 14 or clause 15, further comprising a fourth fluid transfer valve, located in between a second side of the first condenser and the pump.
18. The system of clause 14 or clause 15, further comprising a fourth fluid transfer valve, located in between a condenser side of the first heat exchanger and the pump.
19. The system of any one of clauses 14 to 18, wherein the first heat exchanger is implemented as a cascade plate heat exchanger.
20. The system of any one of clauses 14 to 19, wherein the second heat exchanger is implemented as a small cascade heat exchanger.
21. A system, comprising:
   a first heat exchanger;
   a second heat exchanger, comprising an evaporator side and a condenser side, and connected to the first heat exchanger;
   a compressor, connected to the second heat exchanger and to the first heat exchanger;
   an evaporator, connected to a condenser and to the first heat exchanger;
   the condenser;
   a pump configured to cause refrigerant to flow between the evaporator and the condenser side of the second heat exchanger;
   a first fluid transfer valve, located in between the condenser and the condenser side of the second heat exchanger;
   a second fluid transfer valve, located in between the condenser side of the second heat exchanger and the condenser; and
   a third fluid transfer valve, located in between the condenser side of the second heat exchanger and the pump.
22. The system of clause 21, wherein the first, second, and third fluid transfer valves are configured such that thermosyphon motion is generated within the system.
23. A system, comprising:
   a first heat exchanger;
   a second heat exchanger, comprising an evaporator side and a condenser side, and connected to the first heat exchanger;
   a compressor, connected to the second heat exchanger and to the first heat exchanger;
   an evaporator, connected to a condenser and to the first heat exchanger;
   the condenser;
   a pump configured to cause refrigerant to flow between the evaporator and the condenser side of the second heat exchanger;
   a first fluid transfer valve, located in between the pump and the condenser side of the second heat exchanger;
   a second fluid transfer valve, located in between the condenser side of the second heat exchanger and the evaporator; and
   a third fluid transfer valve, located in between the condenser side of the second heat exchanger and the condenser.
24. A system, comprising:
   a first heat exchanger;
   a second heat exchanger, comprising an evaporator side and a condenser side, and connected to the first heat exchanger, to two condensers;
   a compressor, connected to the second heat exchanger and to the first heat exchanger;
   an evaporator, connected to the condenser side of the second heat exchanger;
   the two condensers;
   a pump configured to cause refrigerant to flow between the evaporator and the condenser side of the second heat exchanger;
   a first fluid transfer valve, located in between a given one of the two condensers and the condenser side of the second heat exchanger;
   a second fluid transfer valve, located in between the condenser side of the second heat exchanger and the given one of the two condensers; and
   a third fluid transfer valve, located in between the condenser side of the second heat exchanger and the pump.

While examples have been described with reference to the figures, it will be understood by those of ordinary skill in the art that various changes in form and details may be made therein without departing from the scope as defined by the following claims.

## Claims

1. A system, comprising:
a first heat exchanger;
a second heat exchanger, comprising an evaporator side and a condenser side, and connected to the first heat exchanger;
a compressor, connected to the second heat exchanger and to the first heat exchanger;
an evaporator, connected to a condenser and to the first heat exchanger;
the condenser;
a pump configured to cause refrigerant to flow between the evaporator and the condenser side of the second heat exchanger;
a first fluid transfer valve, located in between a first side of the condenser and the condenser side of the second heat exchanger;
a second fluid transfer valve, located in between the condenser side of the second heat exchanger and a second side of the condenser; and
a third fluid transfer valve, located in between the condenser side of the second heat exchanger and the pump.

2. The system of claim 1, further comprising a fourth fluid transfer valve, located in between a condenser side of the first heat exchanger, the evaporator, and the second side of the condenser.

3. The system of claim 1, further comprising a fourth fluid transfer valve, located in between the first side of the condenser and the pump.

4. The system of any one of claims 1 to 3, wherein the second heat exchanger is implemented as a brazed plate heat exchanger.

5. The system of any one of claims 1 to 3, wherein the second heat exchanger is implemented as a shell-tube heat exchanger.

6. A system, comprising:
a first heat exchanger;
a second heat exchanger, comprising an evaporator side and a condenser side, and connected to the first heat exchanger;
a compressor, connected to the second heat exchanger and to the first heat exchanger;
an evaporator, connected to a condenser and to the first heat exchanger;
the condenser;
a pump configured to cause refrigerant to flow between the evaporator and the condenser side of the second heat exchanger;
a first fluid transfer valve, located in between the pump and the condenser side of the second heat exchanger;
a second fluid transfer valve, located in between the condenser side of the second heat exchanger, a condenser side of the first heat exchanger, a first side of the condenser, and the evaporator; and
a third fluid transfer valve, located in between the condenser side of the second heat exchanger and the first side of the condenser.

7. The system of claim 6, further comprising a fourth fluid transfer valve, located in between the second fluid transfer valve and the first side of the condenser.

8. The system of claim 6, further comprising a fourth fluid transfer valve, located in between a second side of the condenser and the pump.

9. A system, comprising:
a first heat exchanger;
a second heat exchanger, comprising an evaporator side and a condenser side, and connected to the first heat exchanger, to a first condenser, and to a second condenser;
a compressor, connected to the second heat exchanger and to the first heat exchanger;
an evaporator, connected to the condenser side of the second heat exchanger;
the first condenser;
the second condenser;
a pump configured to cause refrigerant to flow between the evaporator and the condenser side of the second heat exchanger;
a first fluid transfer valve, located in between a first side of the first condenser and the condenser side of the second heat exchanger;
a second fluid transfer valve, located in between the condenser side of the second heat exchanger and a second side of the first condenser; and
a third fluid transfer valve, located in between the condenser side of the second heat exchanger and the pump.

10. The system of claim 9, further comprising a fourth fluid transfer valve, located in between the condenser side of the second heat exchanger, a condenser side of the first heat exchanger, and a second side of the first condenser.

11. The system of claim 9, further comprising a fourth fluid transfer valve, located in between a second side of the first condenser and the pump.

12. The system of claim 9, further comprising a fourth fluid transfer valve, located in between a condenser side of the first heat exchanger and the pump.

13. The system of any of claims 6 to 12, wherein the second heat exchanger is implemented as a small cascade heat exchanger.

14. The system of any one of claims 1 to 13, wherein the first heat exchanger is implemented as a cascade plate heat exchanger.

15. The system of any one of claims 1 to 14, wherein the first, second, and third fluid transfer valves are configured to generate thermosyphon motion within the system.
